(19) Europäisches Patentamt
European Patent Office
Office européen des brevets

(11) **EP 2 103 921 A1**

(12) **EUROPEAN PATENT APPLICATION**
published in accordance with Art. 153(4) EPC

(43) Date of publication:
**23.09.2009 Bulletin 2009/39**

(51) Int Cl.:
*G01N 5/02* (2006.01)    *H01L 41/08* (2006.01)
*H01L 41/18* (2006.01)    *H03H 9/19* (2006.01)

(21) Application number: **07830891.3**

(22) Date of filing: **24.10.2007**

(86) International application number:
**PCT/JP2007/071157**

(87) International publication number:
**WO 2008/050891 (02.05.2008 Gazette 2008/18)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **24.10.2006 JP 2006289273**

(71) Applicant: **Nihon Dempa Kogyo Co., Ltd. Tokyo, 151-8569 (JP)**

(72) Inventors:
• **WAKAMATSU, Shunichi**
  **Sayama-shi**
  **Saitama 3501321 (JP)**
• **KOYAMA, Mitsuaki**
  **Sayama-shi**
  **Saitama 3501321 (JP)**
• **KUKITA, Hiroyuki**
  **Sayama-shi**
  **Saitama 3501321 (JP)**

(74) Representative: **TBK-Patent**
    **Bavariaring 4-6**
    **80336 München (DE)**

(54) **SENSING DEVICE**

(57)    It is an object of the present invention to prevent the deterioration in measurement precision even when the frequency of a piezoelectric resonator changes due to a factor other than the adsorption of a substance to be sensed, in a sensing instrument including a sensing sensor provided with the sensing piezoelectric resonator on whose front surface an adsorption layer for adsorbing the substance to be sensed is formed and which changes in natural frequency by the adsorption of the substance to be sensed.

In the present invention, a sensing instrument includes: a reference sensor including a reference piezoelectric resonator not adsorbing a substance to be sensed; a reference oscillator circuit oscillating the reference piezoelectric resonator; a measuring unit receiving an oscillation output of a sensing oscillator circuit and an oscillation output of the reference oscillator circuit in a time-series manner to measure frequencies of the oscillation outputs of the oscillator circuits; and a data creator creating time-series data of a difference between a frequency in a sensing sensor and a frequency in the reference sensor, based on the frequencies of the oscillation outputs of the oscillator circuits obtained by the measuring unit. Therefore, a frequency change due to a factor other than the adsorption of the substance to be sensed is cancelled.

Fig. 4

EP 2 103 921 A1

**Description**

Technical Field

The present invention relates to a sensing instrument which senses a substance to be sensed based on a natural frequency of a piezoelectric resonator, by using the piezoelectric resonator, for example, a quartz resonator, on whose front surface an adsorption layer for adsorbing a substance to be sensed is formed and whose natural frequency changes by the adsorption of the substance to be sensed.

Background Art

As a method for sensing a trace substance, a sensing instrument using a quartz resonator has been known. This sensing instrument has a quartz sensor in which an adsorption layer for adsorbing a substance to be sensed is formed on a front surface of the quartz resonator, and measures the presence/absence or concentration of the substance to be sensed by utilizing the fact that when the quartz resonator, more particularly, the adsorption layer adsorbs the substance to be sensed, its natural frequency changes according to an adsorption amount of the substance to be sensed, and this sensing instrument is advantageous in that it is applicable to a wide range and has a simple structure as an instrument, and moreover, is capable of measuring even an extremely minute amount of substance because of its high sensitivity.

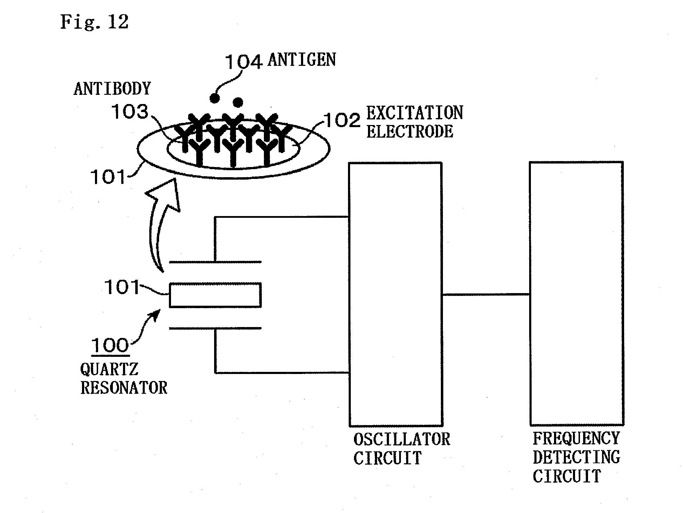

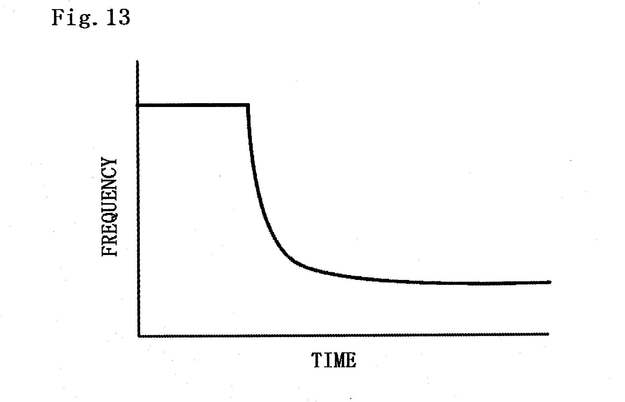

Fig. 12 is a view showing the principle of a bio-related sensing instrument. In this sensing instrument, antibodies 103 capturing antigens by an antigen-antibody reaction are formed as an adsorption layer on an excitation electrode 102 in a film shape formed on a front surface of a quartz piece 101. Therefore, when the antibodies 103 capture the antigens 104, the natural frequency of a quartz resonator 100 changes, causing a change in oscillation frequency of an oscillator circuit 105 as shown in Fig. 13. Therefore, by recording this frequency by a frequency detecting unit 106, a variation in the frequency is known and the concentration of the antigens 104 in a sample solution is known based on this variation.

A patent document 1 describes that a quartz sensor including a Languban-type quartz resonator is attachably/detachaby mounted to a measuring device main body including an oscillator circuit, a sample solution is injected from a liquid injection port of the quartz sensor, an oscillation frequency of the quartz resonator, that is, an output frequency from the oscillator circuit is measured in the measuring device main body side, and for example, the concentration of a substance to be sensed in the sample solution is measured based on the measurement result.

However, not only the capturing of the antigens 104 by the antibodies 103 but also a temperature change ascribable to an airconditioner, the entrance/exit of people, the weather, and the like sometimes cause a change in the oscillation frequency of the quartz resonator 100. The frequency is also sometimes changed when vibration such as vibration when a vehicle passes, when a person walks in a room, and so on is applied to the quartz resonator during the measurement. Still further, in a high-viscosity sample solution such as blood and serum, its viscosity sometimes changes during the measurement, and in this case, the change in viscosity causes a change in the frequency.

When the measuring device has a high measurement resolution, such noises are superimposed on the measurement result, leading to a failure in high-precision measurement. The deterioration in the measurement precision may possibly cause cases where, for example, the determination result becomes "equal to or lower than tolerable concentration" even though a toxic substance whose concentration is over a tolerable range is contained in a river, or the determination result becomes "present" even though a cancer marker is not present in blood, and the incorrect recognition causes a crucial situation.

A patent document 2 describes a method in which a first quartz resonator including an adsorption layer capable of absorbing a substance to be sensed and a second quartz resonator including a dummy layer incapable of adsorbing a substance to be sensed are used, and oscillation outputs of a first oscillator circuit and a second oscillator circuit connected to the respective quartz resonators are mixed by a heterodyne detector, a frequency signal corresponding to a frequency difference between these oscillation outputs is led to a counter, and the frequency is counted. However, since noises of the two frequencies are superimposed on the frequency signal extracted from the heterodyne detector, this method is not suited for measuring a minute amount of a substance to be sensed by using a highresolution measuring device and is difficult to adopt in an actual instrument.

Patent document 1
Japanese Patent Application Laid-open No. 2006-184260
Patent document 2
Japanese Patent Application Laid-open No. 2006-033195

Disclosure of the Invention

The present invention was made to solve the aforesaid problems, and has an object to provide a sensing instrument including a sensing sensor provided with a sensing piezoelectric resonator on whose front surface an adsorption layer for adsorbing a substance to be sensed is formed and which changes in natural frequency by the adsorption of the substance to be sensed, the sensing instrument having less deterioration in the measurement precision even when the frequency of the piezoelectric resonator changes due to a factor other than the adsorption of the substance to be sensed, and thus being capable of high-precision sensing of the substance to be sensed.
The present invention is a sensing instrument sensing a substance to be sensed based on a change in natural frequency of a piezoelectric resonator in which an electrode is provided on a front surface of a piezoelectric resonating piece, the sensing instrument including:

a sensing sensor including a sensing piezoelectric resonator in which an adsorption layer adsorbing the substance to be sensed is formed on a front surface of an electrode and which changes in natural frequency by the adsorption of the substance to be sensed by the adsorption layer;
a sensing oscillator circuit oscillating the piezoelectric resonator;
a reference sensor including a reference piezoelectric resonator not adsorbing the substance to be sensed;
a reference oscillator circuit oscillating the reference piezoelectric resonator;
a measuring unit receiving an oscillation output of the sensing oscillator circuit and an oscillation output of the reference oscillator circuit in a time-division manner to measure frequencies of the oscillation outputs of the oscillator circuits; and
a data creator creating time-series data of a difference between a frequency in the sensing sensor and a frequency in the reference sensor, based on the frequencies of the oscillation outputs of the oscillator circuits obtained by the measuring unit.

In the reference piezoelectric resonator used in the reference sensor, a block layer not adsorbing the substance to be sensed may be formed on a front surface of an electrode in order to prevent the substance to be sensed from being adsorbed by the front surface of the electrode. Alternatively, in the reference piezoelectric resonator, a front surface of an excitation electrode may be in an exposed state, for instance.
For example, the substance to be sensed is an antigen, the adsorption layer is an antibody causing an antigen-antibody reaction with the antigen, and the block layer is an antibody not causing the antigen-antibody reaction.
A sensing instrument of another invention is a sensing instrument sensing a substance to be sensed in a sample solution based on a change in natural frequency of a piezoelectric resonator in which an electrode is provided on a front surface of a piezoelectric resonating piece, the sensing instrument including:

a sensing sensor including a sensing piezoelectric resonator in which an adsorption layer adsorbing the substance to be sensed is formed on a front surface of an electrode and which changes in natural frequency by the adsorption of the substance to be sensed in the sample solution by the adsorption layer;
a sensing oscillator circuit oscillating the piezoelectric resonator;
a reference sensor including a reference piezoelectric resonator and coming into contact with a reference liquid not containing the substance to be sensed;
a reference oscillator circuit oscillating the reference piezoelectric resonator;
a measuring unit receiving an oscillation output of the sensing oscillator circuit and an oscillation output of the reference oscillator circuit in a time-division manner to measure frequencies of the oscillation outputs of the oscillator circuits; and
a data creator creating time-series data of a difference between a frequency in the sensing sensor and a frequency in the reference sensor, based on the frequencies of the oscillation outputs of the oscillator circuits obtained by the measuring unit.

For example, the measuring unit may digitally convert the oscillation outputs of the oscillator circuits to measure the frequencies of the oscillation outputs, and the sensing sensor and the reference sensor each may include a liquid storage part to which the liquid is injected to come into contact with the piezoelectric resonator.
According to the present invention, there are provided the sensing sensor including the sensing piezoelectric resonator which changes in the natural frequency by the adsorption of the substance to be sensed and the reference sensor including the reference piezoelectric resonator not adsorbing the substance to be sensed, and the time-series data of the difference between the frequencies of the outputs oscillated by these sensors is created. Therefore, even if the frequency of the sensing sensor changes due to a factor other than the adsorption of the substance to be sensed, such as, for example, temperature change of a measurement atmosphere or the vibration during the measurement, the change is cancelled, which enables high-precision sensing of the substance to be sensed.

In the other invention, providing the reference sensor coming into contact with the reference liquid not containing the substance to be sensed enables high-precision measurement, similarly to the present invention.

Brief Description of Drawings

Fig. 1 is a view showing the whole structure of a sensing instrument according to an embodiment of the present invention;

Fig. 2 is a vertical sectional view of each quartz sensor included in the sensing instrument;

Fig. 3 is an explanatory view of a quartz resonator included in the quartz sensor;

Fig. 4 is a block diagram showing the structure of the sensing instrument;

Figs. 5 are explanatory views showing the structures of front surfaces of the quartz resonators;

Fig. 6 is a flowchart showing the procedure for the measurement by the sensing instrument;

Figs. 7 are graphs of time-series data obtained by the sensing instrument;

Fig. 8 is a block diagram of a measuring circuit unit included in the sensing instrument;

Fig. 9 is a block diagram of a carrier remover included in the measuring circuit unit;

Fig. 10 is an explanatory chart showing a rotation vector extracted by the block diagram shown in Fig. 9;

Fig. 11 is a graph showing a frequency-temperature characteristic;

Fig. 12 is an explanatory view showing the principle of a conventional sensing instrument; and

Fig. 13 is a graph showing a time-dependent change of a frequency detected by the sensing instrument.

Best Mode for Carrying out the Invention

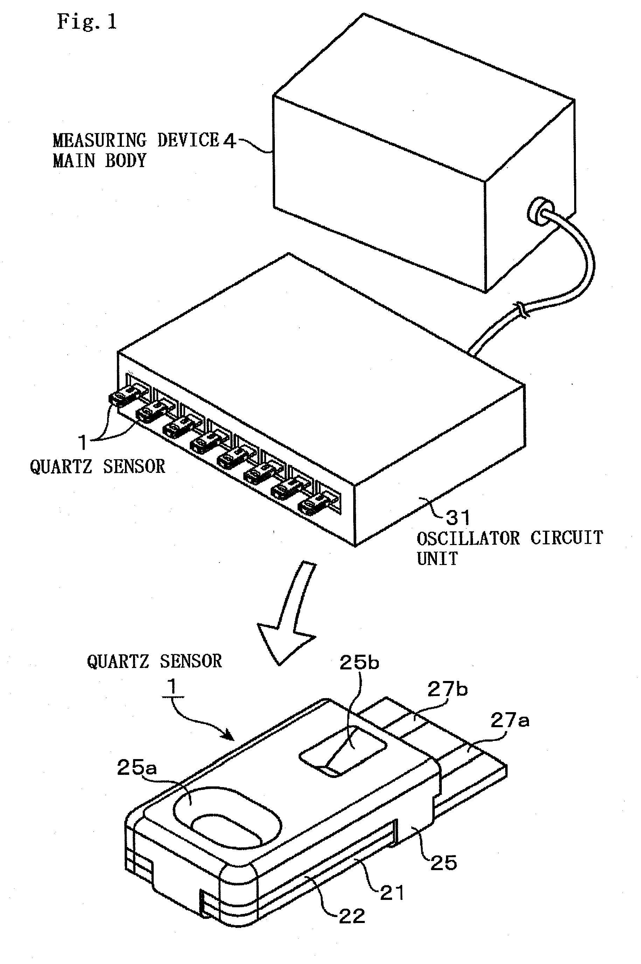

Hereinafter, an embodiment in which a sensing instrument according to the present invention is applied as a bio-sensing instrument will be described. First, the whole structure of the sensing instrument will be briefly described. As shown in Fig. 1, the sensing instrument includes a plurality of, for example, eight quartz sensors 1, an oscillator circuit unit 31 to which the quartz sensors 1 are attachably/detachaby mounted, and a measuring device main body 4 connected to the oscillator circuit unit 31.

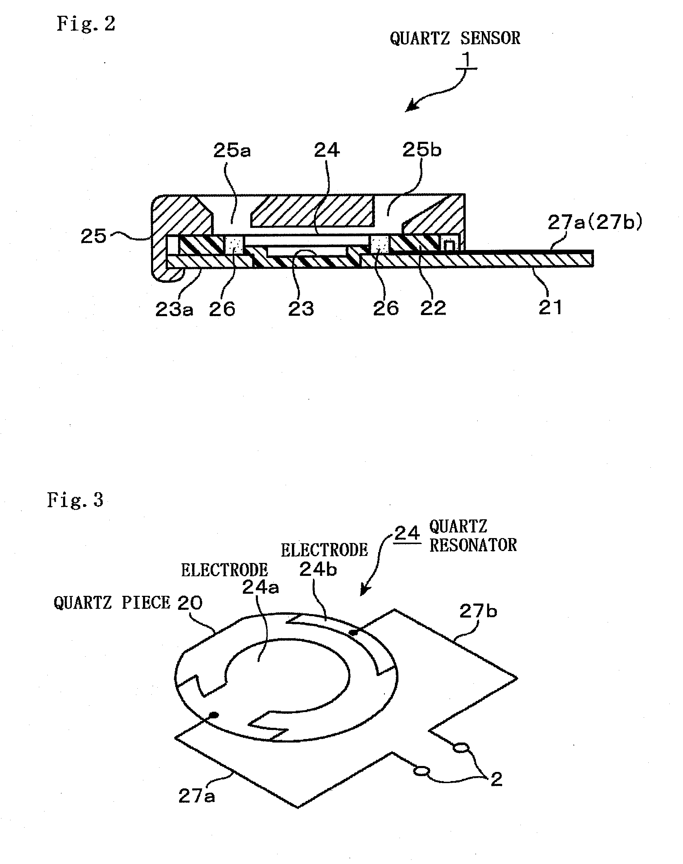

The quartz sensor 1 includes a wiring board, for example, a printed circuit board 21 as shown in Fig. 1 and Fig. 2. The printed circuit board 21 has a rubber sheet 22 stacked on its front surface side in which an opening 23a is formed, and a recessed portion 23 is provided in the rubber sheet 22. On a lower surface side of the rubber sheet 22, a portion corresponding to the recessed portion 23 projects and this projecting portion is fit in the opening 23a. A quartz resonator 24 as a piezoelectric resonator is provided so as to cover the recessed portion 23. That is, one surface side (lower surface side) of the quartz resonator 24 faces the opening 23a side, and on the lower surface side of the quartz resonator 24, the recessed portion 23 forms an airtight space, whereby a Languban-type quartz sensor is formed.

Further, an upper cover case 25 is mounted from above the rubber sheet 22. In the upper cover case 25, there are formed an injection port 25a through which a sample solution as a fluid to be measured is injected and an observation port 25b for the sample solution, and the sample solution is injected from the injection port 25a to fill a space on an upper surface side of the quartz resonator 24 (a quartz piece is immersed in the sample solution).

Incidentally, the quartz sensor 1 may be structured such that the quartz resonator 24 is placed on the front surface of the printed circuit board 21 so as to cover the opening 23a and the rubber sheet 22 presses a peripheral edge portion of the quartz resonator 24.

As shown in Fig. 3, in the quartz resonator 24, electrodes 24a, 24b made of, for example, gold are provided respectively on both surfaces of the quartz piece 20 in, for example, a circular shape (the rear surface-side electrode 24b is formed continuously from a front surface-side peripheral edge portion). These electrodes 24a, 24b are electrically connected via conductive adhesives 26 to printed wirings 27a, 27b, respectively, which are a pair of conductive paths provided in the board 21. In the drawing, 2 denotes terminal parts, which will be described later. In the quartz resonator 24, the structure on the electrode 24a differs depending on whether it is in a reference sensor or in a sensing sensor, which will be described later.

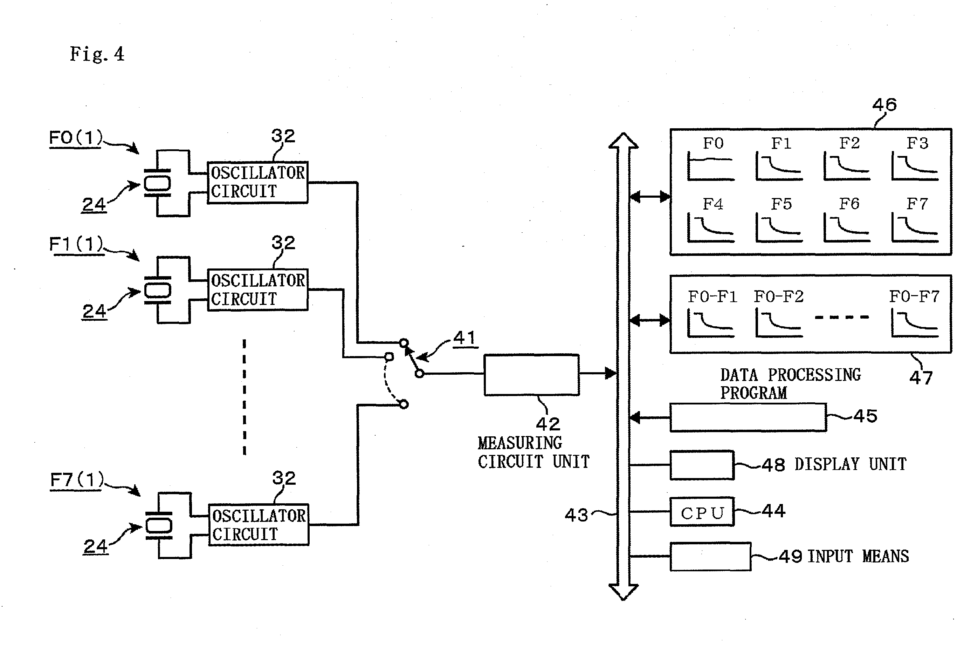

Fig. 4 is a block diagram of the concentration measuring instrument. In this block diagram, the eight quartz sensors 1 mounted to the oscillator circuit unit 31 are denoted by F0 to F7 for convenience sake. The quartz sensor F0 is formed as a reference sensor whose quartz resonator 24 does not adsorb a substance to be sensed when the sample solution is injected, and is used to detect a change in frequency caused by a factor other than the adsorption of the substance to be sensed, the factor being, for example, temperature change of a measurement atmosphere, the vibration during the measurement, or the like.

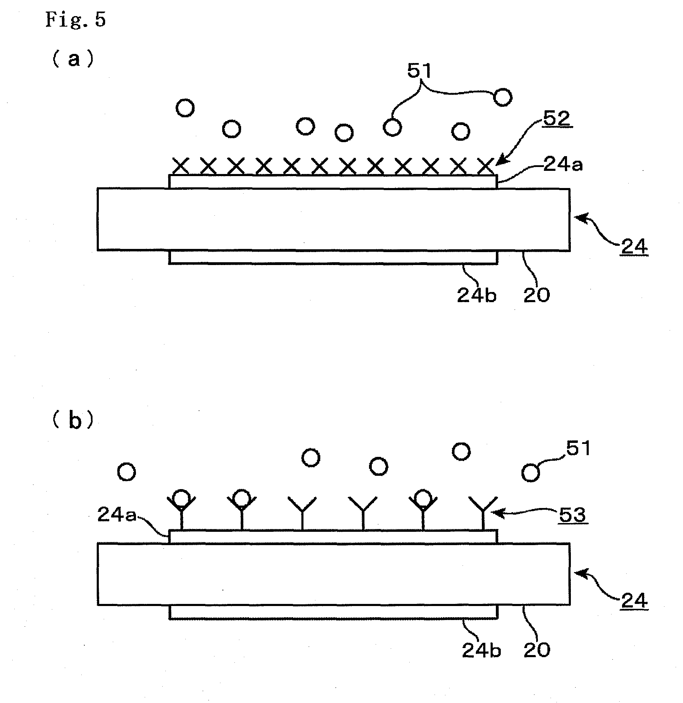

The quartz sensors F1 to F7 are used as sensing sensors each sensing a change in frequency caused by the adsorption of the substance to be sensed in the sample solution by the front surface of the electrode 24a. Fig. 5(a) shows an example of the structure of the front surface of the quartz resonator 24 of the quartz sensor F0. 51 in the drawing denotes the substances to be sensed, 52 in the drawing denotes a block layer made of antibodies (protein) not reacting with the substances to be sensed 51. The block layer 52 covers the front surface of the electrode 24a to prevent the front surface of the electrode 24a from adsorbing the substances to be sensed 51, thereby preventing a change in natural frequency of the quartz resonator 24.

In order to prevent the quartz sensor F0 from adsorbing the substances to be sensed 51, the gold electrode 24a may be in an exposed state (the state of the electrode 24a as it is) depending on the kind of the sample solution, but in this example, since antigens in blood or serum are the substances to be sensed 51, the components in the blood are adsorbed by the gold electrode 24a. Therefore, in order to prevent the gold electrode 24a from adsorbing the components in the blood, protein of some kind is attached on the front surface of the electrode 24a.

Fig. 5(b) shows the structure of the front surface of the quartz resonator 24 of each of the quartz sensors F1 to F7. On the front surface of an excitation electrode 24a thereof, there is provided an adsorption layer 53 made of antibodies selectively reacting with and bonded with antigens which are the substances to be sensed 51, and an antigen-antibody reaction therebetween causes a change in natural frequency of the quartz resonator 24. In the state where the excitation electrode 24a is provided on the quartz piece 20, the quartz resonator 24 of the quartz sensor F0 and the quartz resonator 24 of the quartz sensor F1 have the same frequency-temperature characteristic.

Returning to Fig. 4, the oscillator circuit unit 31 will be described. The oscillator circuit unit 31 includes oscillator circuits 32 oscillating the quartz sensors F0 to F7 respectively, and when the quartz sensors F0 to F7 are inserted to insertion ports thereof shown in Fig. 1, the terminal parts 20 provided in the insertion ports and the printed wirings 27a, 27b of the quartz sensors F0 to F7 are electrically connected, so that the quartz sensors F0 to F7 are electrically connected to the oscillator circuits 32 respectively, resulting in the oscillation of the quartz resonators 2. Then, frequency signals of the quartz sensors F0 to F7 are output to the measuring device main body 4.

Next, the measuring device main body 4 will be described. The measuring device main body 4 includes a measuring circuit unit 42, and in this example, the measuring circuit unit 42 digitally processes a given frequency signal, which is an input signal, to measure the frequency. An example of the concrete circuit configuration of the measuring circuit unit 42 will be described later for easier understanding of the present invention, and it analog/digital-converts (A/D-converts) the frequency signals from the oscillator circuits 32 to apply signal processing to the resultant digital signals, thereby detecting the frequencies. Further, on a preceding stage of the measuring circuit unit 42, a switching unit 41 is provided to sequentially send output signals from the oscillator circuits 32 corresponding to the quartz sensors F0 to F7 respectively to the measuring circuit unit 42. That is, the switching unit 41 obtains the frequency signals from the eight quartz sensors F0 to F7 (frequencies from the eight oscillator circuits 32) in a time-division manner, so that the measuring circuit unit 42 is capable of finding the frequencies of the eight quartz sensors F0 to F7 in parallel. For example, as will be described later, one second is divided into eight segments and the frequency of each channel is sequentially found by 1/8 second processing, and therefore, strictly speaking, the measurement is not the complete simultaneous measurement, but since the frequencies are obtained during one second, it can be said that the frequencies of the quartz sensors F0 to F7 are obtained substantially simultaneously.

Returning to Fig. 4, the measuring device main body 4 includes a date bus 43, and to the data bus 43, a CPU 44, a data processing program 45, a first memory 46, a second memory 47, and the above-described measuring circuit unit 42 are connected. Further, the measuring device main body 4 is connected to a personal computer or the like, which is not shown in Fig. 1, and a display unit 48 such as a monitor and an input means 49 such as a keyboard are connected to the data bus 42.

The data processing program 45 is a data creator and is configured to execute later-described steps. Concretely, the program 45 includes: a step of obtaining time-series data of the oscillation frequencies of the quartz sensors F0 to F7 based on signals output from the measuring circuit unit 42; a step of calculating differences between the time-series data of the quartz sensor F0 and the time-series data of the quartz sensors F1 to F7 in the same time zone, a step of obtaining time-series data of the differences; a step of displaying the data on the display unit 48 in response to a user's selection.

Next, the operation of the sensing instrument as structured above will be described, but one of the characteristics of the sensing instrument of the present invention is to use the reference sensor and the sensing sensors, and their usage patterns include various kinds. Examples of their usage patterns are to inject the same sample solution in all the seven quartz sensors F1 to F7 which are the sensing sensors and calculate differences between the frequencies of the quartz sensors F1 to F7 and the frequency of the quartz sensor F0 which is the reference sensor, or to inject different sample solutions to the seven quartz sensors F1 to F7 and similarly calculate frequency differences. In the former case, data of the seven obtained frequency differences are compared and, for example, an average value of these frequency differences is regarded as the frequency difference data. In the latter case, the frequency difference data for the seven kinds of sample solutions are collectively obtained. Still another usage is to use one of the quartz sensors F1 to F7 and the quartz sensor F0 and inject the same sample solution to them, and not to use the other channels. Any of these usage methods is appropriately selected according to a user-side need, the kind of the sample solution, the purpose of the measurement, and so on.

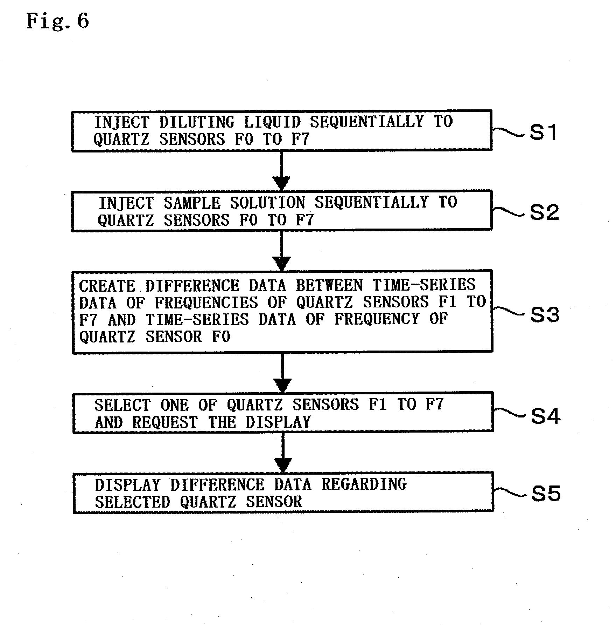

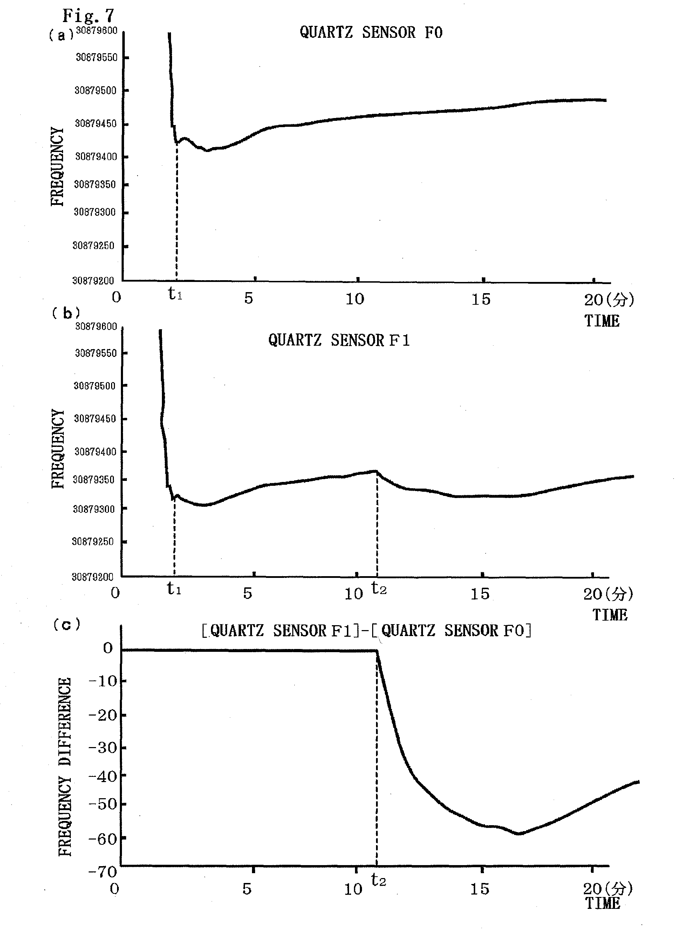

Here, an example of a method of finding the concentration of some kind of antigen in blood or serum will be described with reference to Fig. 6 and Fig. 7. First, the quartz sensor F0 and the quartz sensors F1 to F7 are inserted to the insertion ports of the oscillator circuit unit 31. Consequently, the oscillator circuits 32 of the respective channels oscillate. Then, the oscillation outputs are sequentially sent to the measuring circuit unit 42 by the switching unit 41 to be A/D-converted by the measuring circuit unit 42, and the resultant digital values are subjected to signal processing and the frequencies of the frequency signals of the eight channels are found substantially simultaneously (for example, at 1/8 second time intervals) and the found frequencies are stored in the first memory 46.

Next, for example, a salt water as a diluting liquid is injected to the quartz sensor F0 and the quartz sensors F1 to F7 (Step S1). Consequently, environmental atmospheres of the quartz resonators 24 change from a vapor phase to a liquid phase, so that the frequencies of the channels become lower. Meanwhile, serums taken from different human bodies are diluted by a diluting liquid, for example, a salt water to 100 times, and the resultant seven samples are prepared. Then, these seven sample solutions are injected to the quartz sensors F1 to F7 respectively, and one of the sample solutions is injected to the quartz sensor F0 (Step S2). In this manner, the time-series data of the frequencies of the oscillation outputs regarding the respective channels (quartz sensors F0 to F7) are stored in the first memory 46, and at the same time, differences between the frequency of the quartz sensor F0 and the frequencies of the quartz sensors F1 to F7 are calculated and the time-series data of these differences are stored in the second memory 47 (Step S3). A frequency corresponding to each of the differences may be found at a timing while the frequencies of the quartz sensors F0 to F7 are sequentially obtained. An example of a possible method is such that, after the frequency (f0) of the quartz sensor F0 is obtained and then the frequency (f1) of the quartz sensor F1 is obtained, f1 is subtracted from f0 and the difference therebetween is written to the second memory 47, and after the frequency (f2) of the quartz sensor F2 is next obtained, f2 is subtracted from f0 and the difference therebetween is written to the second memory 47. A possible alternative method is such that, after the time-series data of the frequencies of the respective channels are obtained, the differences are calculated at a predetermined timing, with the time axes of these data being aligned, and the data are created from the time-series of the differences.

Subsequently, when, out of the quartz sensors F1 to F7, a user selects one quartz sensor whose difference data from the quartz sensor F0 he/she wants to display, by using, for example, the input means 49 (Step S4), the difference data selected from the time-series data in the second memory 47 is displayed as a graph on the display unit 48 (Step S5). When the quartz sensor F1 is selected, for instance, the graph of the difference data between the quartz sensor F1 as the sensing sensor and the quartz sensor F0 as the reference sensor is displayed on the display unit 48 as shown in Fig. 7(c). How the difference data in Fig. 7(c) is obtained will be described in detail. First, as shown in Figs. 7(a), (b), the frequencies of the quartz sensors F0, F1 decrease by the injection of the diluting liquid at a time t1. Note that, though the injection timings of the diluting liquid to the quartz sensors F0, F1 are not the same, since the sample solution is injected to the quartz sensor F1 after the frequencies are stabilized after the injection of the diluting liquid, it is previously described, for convenience sake, that the diluting liquid and the sample solution are both injected simultaneously. Then, when the sample solution is injected to the quartz sensors F0, F1 at a time t2, the antigens in the sample solution are not adsorbed (captured) in the quartz sensor F0, but the antigens are adsorbed in the quartz resonator F1. Therefore, the injection of the sample solution does not cause a change in the frequency of the quartz sensor F0, but the difference frequency equal to the frequency of the quartz sensor F0 from which the frequency of the quartz sensor F1 is subtracted decreases at the time t2 as shown in Fig. 7(c).

Even if there occurs a change in environmental temperature, vibration application, or a change in viscosity of the sample solution (serum) during such a series of operations, frequency variation ascribable to the change occurs both in the quartz sensors F0, F1. Therefore, the decrease in the frequency in the difference frequency is only ascribable to the adsorption of the antigens by the quartz resonator 24. In Fig. (c), the difference frequency at its stabilized state is at the "0" position of the vertical axis, and this is because the difference between the quartz sensors F0, F1 when only the diluting liquid is contained is added to cancel an offset, and even displaying it without canceling the offset does not affect the measurement at all.

The user is capable of measuring the concentration of the target antigens contained in the sample solutions injected to the quartz sensors F1 to F7, by using the difference data thus displayed and a calibration curve showing the pre-found concentration and the frequency variation.

According to this embodiment, there are provided the quartz sensor F0 as the reference sensor not adsorbing the target antigens and the quartz sensors F1 to F7 including the quartz resonators 24 changing in natural frequency by the adsorption of the antigens, and the time-series data of the differences in the oscillation frequency between the quartz sensor F0 and the quartz sensors F1 to F7 are found. This can cancel a frequency change caused by a factor other than the adsorption of the antigens by the quartz sensors F1 to F7, such as temperature change of a measurement atmosphere or the vibration during the measurement. As a result, high-precision sensing of the antigens and the measurement of the concentration thereof are enabled.

In the foregoing, a reference liquid not containing the substances to be sensed may be injected to the quartz sensor F0, and in this case, its quartz resonator 24 may have the exposed gold electrode 24a without the aforesaid block layer 52 being formed, or the quartz resonator 24 having the antibodies similarly to the quartz sensors F1 to F7 may be used.

As the reference liquid, a diluted solution of the sample solution, pure water, or the like is usable. In this case, irrespective of the front surface state of the quartz resonator 24, the antigen-antibody reaction does not occur, and therefore, substantially the same operations and effects as those of the above-described embodiment are obtained. However, in a case where the viscosity of the sample solution changes during the measurement as in, for example, a blood test, the method of the above-described embodiment is more preferable. For example, in a case where substantially no time-dependent change of viscosity occurs as in a water analysis of a river, such a quartz sensor can be used as the reference sensor. Incidentally, in the above-described example, the diluted serum is the sample solution, but diluted blood may be used.

Further, the present invention may be used in creating a calibration curve showing a relation between the concentration of a substance to be sensed and a frequency change of the quartz resonator 24. Still further, the sensing instrument of the present invention is not limited to one sensing substances to be sensed in a liquid but may be one sensing substances to be sensed in gas. Further, the purpose of the sensing of substances to be sensed is not limited to the finding of the concentration but may be the examination of the absence/presence of the substances to be sensed.

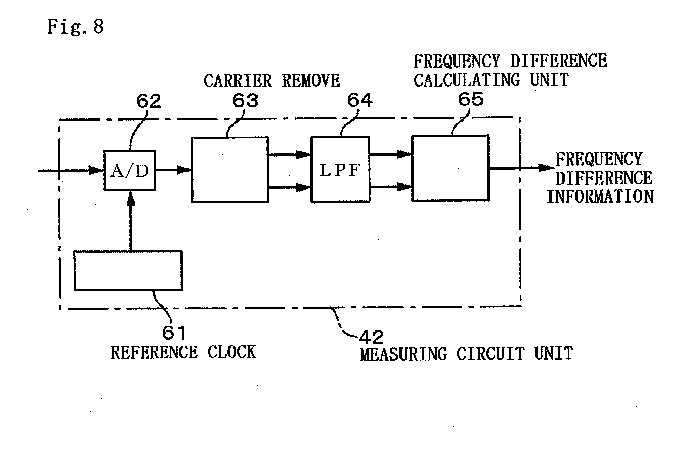

Here, a concrete example of a preferred structure as the measuring circuit unit digitally measuring the frequencies of the frequency signals of the quartz sensors F0 to F7 is shown in Fig. 8. 61 denotes a reference clock generating unit, and it outputs a clock signal, which is a frequency signal with extremely stable frequency, in order to sample the frequency signal from the switching unit 41. 62 denotes an A/D (analog/digital) converter, and it samples the frequency signal based on the clock signal from the reference clock generating unit 61 and outputs the sampling value as a digital signal. For example, fc and fs can be set to 11 MHz and 12 MHz respectively, where fc is the frequency of the frequency signal and fs is the sampling frequency (frequency of the clock signal). In this case, a fundamental wave of the frequency signal specified by the output signal from the A/D converter 62 which is the digital signal is a 1 MHz sinusoidal wave.

On a subsequent stage of the A/D converter 62, a carrier remove 63 and a low-pass filter 64 are provided in this order. The carrier remove 63 and the low-pass filter 64 are used to extract a rotation vector which rotates at a frequency corresponding to a difference between, for example, the frequency of the 1 MHz sinusoidal signal specified by the digital signal from the A/D converter 62 and the frequency of a sinusoidal signal used for quadrature detection.

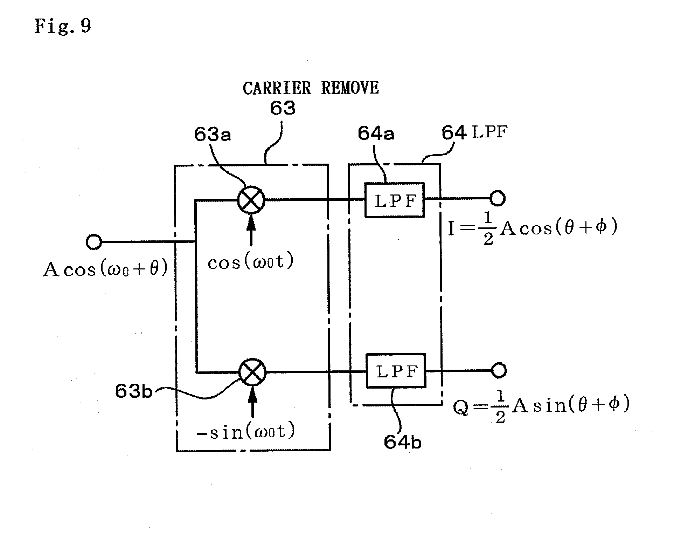

For easier understanding of the operation of extracting the rotation vector, the sinusoidal signal specified by the digital signal from the A/D converter 62 is defined as $A\cos(\omega 0t + \theta)$. As shown in Fig. 9, the carrier remove 63 includes a multiplying unit 63a multiplying the sinusoidal signal by $\cos(\omega 0t)$ and a multiplying unit 63b multiplying the sinusoidal signal by $-\sin(\omega 0t)$. That is, by such arithmetic operations, the quadrature detection is performed. An output of the multiplying unit 63a and an output of the multiplying unit 63b are expressed by an expression (2) and an expression (3) respectively.

$$A\cos(\omega 0t + \theta) \bullet \cos(\omega 0t)$$

$$= 1/2 \bullet A\cos\theta + 1/2\{\cos(2\omega 0t) \bullet \cos\theta + \sin(2\omega 0t) \bullet \sin\theta\} \ldots (2)$$

$$A\cos(\omega 0t + \theta) \bullet -\sin(\omega 0t)$$

$$= 1/2 \bullet A\sin\theta - 1/2\{\sin(2\omega 0t) \bullet \cos\theta + \cos(2\omega 0t) \bullet \sin\theta\} \ldots (3)$$

Therefore, when the output of the multiplying unit 63a and the output of the multiplying unit 63b are passed through low-pass filters 64a and 64b respectively, the $2\omega 0t$ frequency signal is filtered out, and as a result, $1/2 \bullet A\cos\theta$ and $1/2 \bullet A\sin\theta$ are extracted from the low-pass filter 64.

Then, when the frequency of the sinusoidal signal expressed as $A\cos(\omega 0t + \theta)$ changes, $A\cos(\omega 0t + \theta)$ becomes $A\cos(\omega 0t + \theta + \omega 1t)$. Note that $\omega 1$ is sufficiently smaller than $\omega 0$. Therefore, $1/2 \bullet A\cos\theta$ becomes $1/2 \bullet A\cos(\theta + \omega 1t)$, and $1/2 \bullet A\sin\theta$ becomes $1/2 \bullet A\sin(\theta + \omega 1t)$. That is, the output obtained from the low-pass filter 84 is a signal corresponding to a variation $\omega 1/2\pi$ of the frequency of the sinusoidal signal $[A\cos(\omega 0t + \theta)]$. That is, these values are a real part (I) and an imaginary part (Q) which are complex expression of the rotation vector rotating at the frequency corresponding to the difference between the frequency of the sinusoidal signal specified by the digital signal from the A/D converter 62 and the frequency ω0/2π of the sinusoidal signal used for the quadrature detection.

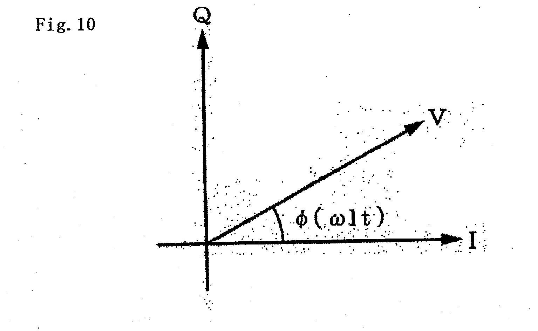

Fig. 10 is a chart showing the rotation vector, and an angular velocity of the rotation vector is ω1. Therefore, if the input frequency of the A/D converter 62 when the rotation vector is stopped is found in advance, the angular velocity ω1t of the rotation vector is found at the time of the measurement, so that the frequency of the oscillator circuit 32 is known. A frequency calculating unit 65 provided on a subsequent stage of the low-pass filter 64 is a part to find the angular velocity ω1 of the rotation vector and calculate the oscillation frequency of the oscillator circuit 32 based on the found value. The measuring circuit unit using the rotation vector is described in detail in Japanese Patent Application Laid-open No. 2006-258787.

Then, the frequency signals of the quartz sensors F0 to F7 are successively taken into the A/D converter 62 at 1/8 second time intervals, and therefore, the frequency calculating unit 65 monitors the rotation vector corresponding to, for example, the quartz sensor F0 for 1/8 second, concretely, detects a change in the rotation vector at every timing of a calculation clock, and it may evaluate the change as a frequency in a 1/8 second time zone. Similarly, the frequency calculating unit 65 finds the frequency of the next quartz sensor F1 in the next 1/8 second and thus finds the frequencies of the eight channels during one second. Incidentally, the circuit part from the carrier remove 63 to the frequency calculating unit 65 may be prepared for the eight channels and the frequencies of the channels may be found by the respective circuit parts.

Here, a frequency difference between a frequency $F_{2Laa}$ and a frequency $F_{1L}$ is expressed by the following expression, where $F_{2Laa}$ is the frequency when the quartz resonator in the sensing sensor comes into contact with the sample solution and the antigen-antibody reaction is finished, and $F_{1L}$ is the frequency when the quartz resonator in the reference sensor comes into contact with the sample solution and this frequency is stabilized.

[Numerical Expression 1]

Note that $Fr_2$, $Fr_1$ are a series resonance frequency of the quartz resonator of the sensing sensor and a series resonance frequency of the quartz resonator of the reference sensor respectively, $dFr_2$, $dFr_1$ are a decrement in the frequency of the quartz resonator of the sensing sensor ascribable to the viscosity of the liquid and a decrement in the frequency of the quartz resonator of the reference sensor ascribable to the viscosity of the liquid respectively, and $(df/f)_{2L}$, $(df/f)_{1L}$ are a variation in the frequency of the quartz resonator of the sensing sensor due to a temperature characteristic and a variation in the frequency of the quartz resonator of the reference sensor due to a temperature characteristic respectively. Further, $dFr_{2x}$ is a variation in the frequency caused by the capturing of the antigens by the quartz resonator of the sensing sensor. $(df/f)_{2L}$ and $(df/f)_{1L}$ are expressed as follows (the following expression (1) and expression (2)) respectively, where T is temperature.

$$(df/f)_{2L} = a_{2L} \bullet T^3 + b_{2L} + T^2 + c_{2L} + T + d_{2L} \dots (1)$$

$$(df/f)_{1L} = a_{1L} \bullet T^3 + b_{1L} + T^2 + c_{1L} + T + d_{1L} \dots (2)$$

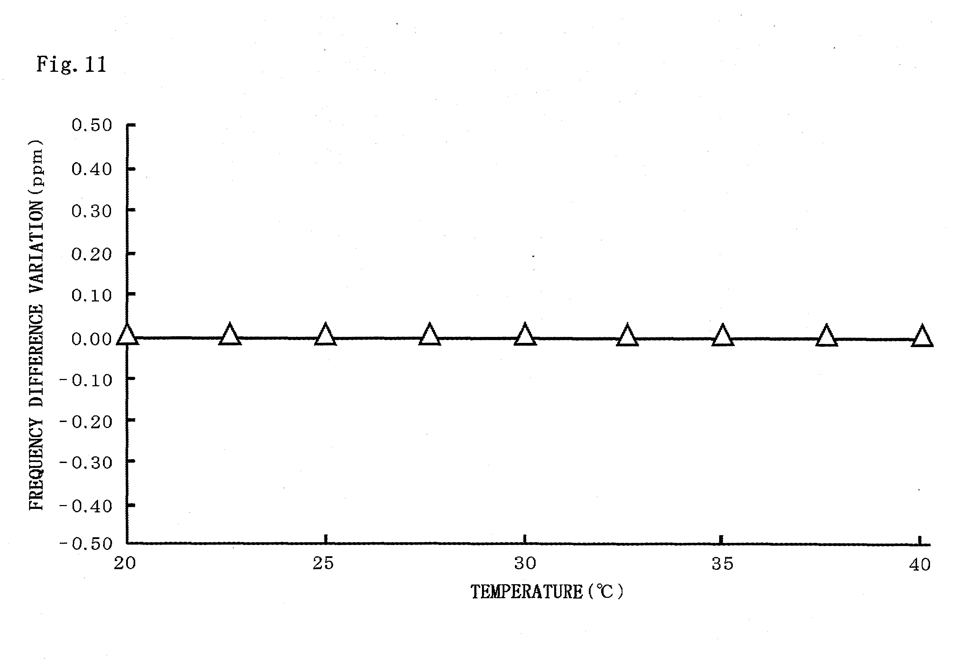

In the simulation in which the difference between the series resonance frequencies of the both quartz resonators is set to 590 Hz, the decrement ($dFr_{2x}$) in the frequency ascribable to the occurrence of the antigen-antibody reaction is set to 3. 29 kHz, the frequency-temperature characteristic of the frequency difference ($dFr_{12L}$) between the both quartz resonators is as shown in Fig. 11, and it has been confirmed that a variation in the frequency in a 20°C to 40°C range is extremely small, that is, about 0.2 ppm.

**Claims**

**1.** A sensing instrument sensing a substance to be sensed based on a change in natural frequency of a piezoelectric resonator in which an electrode is provided on a front surface of a piezoelectric resonating piece, the sensing instrument comprising:

a sensing sensor including a sensing piezoelectric resonator in which an adsorption layer adsorbing the substance to be sensed is formed on a front surface of an electrode and which changes in natural frequency by the adsorption of the substance to be sensed by the adsorption layer;
a sensing oscillator circuit oscillating the piezoelectric resonator;
a reference sensor including a reference piezoelectric resonator not adsorbing the substance to be sensed;

a reference oscillator circuit oscillating the reference piezoelectric resonator;

a measuring unit receiving an oscillation output of the sensing oscillator circuit and an oscillation output of the reference oscillator circuit in a time-division manner to measure frequencies of the oscillation outputs of the oscillator circuits; and

a data creator creating time-series data of a difference between a frequency in the sensing sensor and a frequency in the reference sensor, based on the frequencies of the oscillation outputs of the oscillator circuits obtained by the measuring unit.

2. The sensing instrument according to claim 1, wherein, in the reference piezoelectric resonator used in the reference sensor, a block layer not adsorbing the substance to be sensed is formed on a front surface of an electrode in order to prevent the substance to be sensed from being adsorbed by the front surface of the electrode.

3. The sensing instrument according to claim 2, wherein the substance to be sensed is an antigen, the adsorption layer is an antibody causing an antigen-antibody reaction with the antigen, and the block layer is an antibody not causing the antigen-antibody reaction.

4. The sensing instrument according to claim 1, wherein, in the reference piezoelectric resonator, a front surface of an excitation electrode is in an exposed state.

5. A sensing instrument sensing a substance to be sensed in a sample solution based on a change in natural frequency of a piezoelectric resonator in which an electrode is provided on a front surface of a piezoelectric resonating piece, the sensing instrument comprising:

a sensing sensor including a sensing piezoelectric resonator in which an adsorption layer adsorbing the substance to be sensed is formed on a front surface of an electrode and which changes in natural frequency by the adsorption of the substance to be sensed in the sample solution by the adsorption layer;

a sensing oscillator circuit oscillating the piezoelectric resonator;

a reference sensor including a reference piezoelectric resonator and coming into contact with a reference liquid not containing the substance to be sensed;

a reference oscillator circuit oscillating the reference piezoelectric resonator;

a measuring unit receiving an oscillation output of the sensing oscillator circuit and an oscillation output of the reference oscillator circuit in a time-division manner to measure frequencies of the oscillation outputs of the oscillator circuits; and

a data creator creating time-series data of a difference between a frequency in the sensing sensor and a frequency in the reference sensor, based on the frequencies of the oscillation outputs of the oscillator circuits obtained by the measuring unit.

6. The sensing instrument according to claim 1 or 5, wherein the measuring unit digitally converts the oscillation outputs of the oscillator circuits to measure the frequencies of the oscillation outputs.

7. The sensing sensor according to claim 1 or 5, wherein the sensing sensor and the reference sensor each includes a liquid storage part to which the liquid is injected to come into contact with the piezoelectric resonator.

Fig. 1

MEASURING DEVICE 4
MAIN BODY

1

QUARTZ SENSOR

31
OSCILLATOR CIRCUIT
UNIT

QUARTZ SENSOR

1

25b

27b

27a

25a

25

21

22

Fig. 2

QUARTZ SENSOR
1

25a    24    25b

25

27a(27b)

23a  26    23    26  22    21

Fig. 3

24 QUARTZ
RESONATOR

ELECTRODE
24b

ELECTRODE
24a

QUARTZ PIECE 20

27b

27a

2

Fig. 4

F0  F1  F2  F3
F4  F5  F6  F7

46

F0-F1  F0-F2  ·····  F0-F7

47

45 DATA PROCESSING PROGRAM

48 DISPLAY UNIT

44 CPU

49 INPUT MEANS

43

42 MEASURING CIRCUIT UNIT

41

32 OSCILLATOR CIRCUIT

32 OSCILLATOR CIRCUIT

32 OSCILLATOR CIRCUIT

F0(1)  24

F1(1)  24

F7(1)  24

Fig. 5

（a）

51

52

X X X X X X X X X X X X

24a

24

24b 20

（b）

51

24a

53

24

24b 20

Fig. 6

```
┌─────────────────────────────────────────────┐
│  INJECT DILUTING LIQUID SEQUENTIALLY TO      │  ～S1
│  QUARTZ SENSORS F0 TO F7                      │
└─────────────────────────────────────────────┘
                     │
                     ▼
┌─────────────────────────────────────────────┐
│  INJECT SAMPLE SOLUTION SEQUENTIALLY TO      │  ～S2
│  QUARTZ SENSORS F0 TO F7                      │
└─────────────────────────────────────────────┘
                     │
                     ▼
┌─────────────────────────────────────────────┐
│  CREATE DIFFERENCE DATA BETWEEN TIME-SERIES  │
│  DATA OF FREQUENCIES OF QUARTZ SENSORS F1 TO │  ～S3
│  F7 AND TIME-SERIES DATA OF FREQUENCY OF     │
│  QUARTZ SENSOR F0                             │
└─────────────────────────────────────────────┘
                     │
                     ▼
┌─────────────────────────────────────────────┐
│  SELECT ONE OF QUARTZ SENSORS F1 TO F7       │  ～S4
│  AND REQUEST THE DISPLAY                      │
└─────────────────────────────────────────────┘
                     │
                     ▼
┌─────────────────────────────────────────────┐
│  DISPLAY DIFFERENCE DATA REGARDING           │  ～S5
│  SELECTED QUARTZ SENSOR                       │
└─────────────────────────────────────────────┘
```

Fig. 7

(a)

QUARTZ SENSOR F0

(b)

QUARTZ SENSOR F1

(c)

[QUARTZ SENSOR F1]-[QUARTZ SENSOR F0]

Fig. 8

CARRIER REMOVE

FREQUENCY DIFFERENCE
CALCULATING UNIT

62        63        64        65

A/D    [          ]    L P F    [          ]    →  FREQUENCY
                                                    DIFFERENCE
                                                    INFORMATION

[          ]

61
REFERENCE CLOCK

42
MEASURING CIRCUIT UNIT

Fig. 9

CARRIER REMOVE
63

63a    64a    64 LPF

63b

$A\cos(\omega_0+\theta)$

$\cos(\omega_0 t)$

$-\sin(\omega_0 t)$

LPF

LPF

$I=\dfrac{1}{2}A\cos(\theta+\phi)$

$Q=\dfrac{1}{2}A\sin(\theta+\phi)$

64b

Fig. 10

$\phi(\omega 1 t)$

Fig. 11

Fig. 12

Fig. 13

**INTERNATIONAL SEARCH REPORT**

International application No.

PCT/JP2007/071157

A.  CLASSIFICATION OF SUBJECT MATTER
*G01N5/02*(2006.01)i,  *H01L41/08*(2006.01)i,  *H01L41/18*(2006.01)i,  *H03H9/19*
(2006.01)i

According to International Patent Classification (IPC) or to both national classification and IPC

B.  FIELDS SEARCHED

Minimum documentation searched (classification system followed by classification symbols)
G01N5/02, H01L41/08, H01L41/18, H03H9/19

Documentation searched other than minimum documentation to the extent that such documents are included in the fields searched
Jitsuyo Shinan Koho          1922-1996   Jitsuyo Shinan Toroku Koho   1996-2007
Kokai Jitsuyo Shinan Koho    1971-2007   Toroku Jitsuyo Shinan Koho   1994-2007

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| Y | JP 2006-184260 A  (Nihon Dempa Kogyo Co., Ltd.), 13 July, 2006 (13.07.06), Full text; all drawings & WO 2006/070940 A1 | 1-7 |
| Y | JP 10-132646 A  (Ricoh Co., Ltd.), 22 May, 1998 (22.05.98), Full text; all drawings (Family: none) | 1-7 |
| Y | JP 7-103873 A  (Nippon Telegraph And Telephone Corp.), 21 April, 1995 (21.04.95), Full text; all drawings (Family: none) | 1-7 |

☒  Further documents are listed in the continuation of Box C.          ☐  See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered   to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| 10 December, 2007 (10.12.07) | 25 December, 2007 (25.12.07) |

| Name and mailing address of the ISA/ | Authorized officer |
|---|---|
| Japanese Patent Office | |
| Facsimile No. | Telephone No. |

Form PCT/ISA/210 (second sheet) (April 2007)

<table>
<tr><td colspan="2"><b>INTERNATIONAL SEARCH REPORT</b></td><td>International application No.<br><br>PCT/JP2007/071157</td></tr>
</table>

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 6-167435 A  (NKK Corp.),<br>14 June, 1994 (14.06.94),<br>Full text; all drawings<br>(Family: none) | 1-7 |
| Y | JP 2006-33195 A  (Nihon Dempa Kogyo Co., Ltd.),<br>02 February, 2006 (02.02.06),<br>Full text; all drawings<br>(Family: none) | 1-7 |

Form PCT/ISA/210 (continuation of second sheet) (April 2007)

**REFERENCES CITED IN THE DESCRIPTION**

**Patent documents cited in the description**

- JP 2006184260 A
- JP 2006033195 A
- JP 2006258787 A